# FASCICULE DE BREVET EUROPEEN

(11) **EP 3 182 814 B1**
(45) Date de publication et mention de la délivrance du brevet: **17.05.2023**
(21) Numéro de dépôt: 16204391.3
(22) Date de dépôt: 15.12.2016
(51) Int. Cl.: H05K 7/20, F28F 3/12

(54) **CIRCUIT DE REFROIDISSEMENT ET DISPOSITIF ELECTRIQUE COMPRENANT LE CIRCUIT DE REFROIDISSEMENT**
KÜHLKREISLAUF UND ELEKTRISCHE VORRICHTUNG, DIE EINEN SOLCHEN KÜHLKREISLAUF UMFASST
COOLING CIRCUIT AND ELECTRICAL DEVICE COMPRISING THE COOLING CIRCUIT

(30) Priorité: 17.12.2015 FR 1562713
(43) Date de publication de la demande: 21.06.2017
(73) Titulaire: Valeo eAutomotive France SAS, 95800 Cergy (FR)
(72) Inventeur: SMAL, Pierre, 78500 SARTROUVILLE (FR); BONVALLAT, Guillaume, 60110 MERU (FR); GOVINDASSAMY, Valery, 95800 CERGY (FR)
(74) Mandataire: Valeo Powertrain Systems

(56) Documents cités:
- US-A1- 2010 328 892
- US-A1- 2013 171 493
- US-A1- 2014 104 811

## Description

La présente invention concerne un circuit de refroidissement apte à recevoir un fluide de refroidissement, et un dispositif électrique comprenant un tel circuit de refroid issement.

On connait des circuits de refroidissement recevant un fluide de refroidissement pour dissiper une chaleur produite par des composants électriques d'un dispositif électrique tel qu'un convertisseur de tension. Typiquement, le circuit de refroidissement comprend un boitier et un capot fermant le boitier définissant ainsi un ou des canaux de circulation du fluide de refroidissement. Le capot est généralement maintenu sur le boitier grâce à des vis. Un joint d'étanchéité est positionné entre le capot et le boitier pour réaliser une étanchéité du circuit de refroidissement. Les vis permettent généralement de maintenir un effort entre le capot et le boitier pendant la durée de vie du dispositif électrique, malgré les différentiels de température qui apparaissent entre la portion du boitier en contact avec le composant électrique et celle en contact avec le fluide de refroidissement. Cependant, dans certaines applications, où l'espace est limité, les têtes de vis peuvent avoir une largeur ou une hauteur qui pénalisent l'encombrement du circuit de refroidissement, et donc du dispositif électrique. Les vis doivent assurer la compression du joint d'étanchéité ce qui entraine un couple de serrage des vis ou un diamètre des vis qui sont difficilement compatibles avec certaines épaisseurs de boitier ou de capot.

Les documents US 2010/328892, US 2013/171493 et US 2014/104811 présentent le boîtier et le capot reliés à l'aide de colle, de fixations mécaniques ou d'une combinaison de ceux-ci.

Il est donc recherché un moyen de fixation entre le capot et le boitier d'un circuit de refroidissement qui permet d'assurer une étanchéité entre le capot et le boitier avec un encombrement limité.

A cet effet, l'invention propose un circuit de refroidissement apte à recevoir un fluide de refroidissement, configuré pour être intégré dans un dispositif électrique, ledit circuit de refroidissement comprenant :
- un boitier formant une cavité configurée pour recevoir ledit fluide de refroidissement,
- un capot fermant une ouverture de la dite cavité de manière à définir un canal de circulation dudit fluide de refroidissement,
- une couche de colle entre ledit capot et la périphérie de ladite ouverture et des rivets, la couche de colle et les rivets étant configurés de sorte à fixer de manière étanche ledit capot sur la périphérie de ladite ouverture dans lequel la couche de colle s'étend continûment autour de l'ouverture sur une première portion périphérique de l'ouverture et les rivets sont situés sur une deuxième portion périphérique de l'ouverture externe par rapport à la première portion périphérique.

Ainsi, le capot est maintenu sur le boitier par deux moyens de fixation, à savoir par la couche de colle et par les rivets. L'association de ces deux moyens de fixation permet d'être moins contraint sur l'effort exercé sur le capot par le rivet, ce qui permet d'avoir une épaisseur de capot plus faible que dans l'art antérieur. La couche de colle permet une fixation du capot sur le boitier, mais aussi une étanchéité entre le capot et le boitier. Les rivets permettent de maintenir le capot en place pendant la polymérisation de la couche de colle.

Par exemple, le circuit de refroidissement est dépourvu de joint d'étanchéité supplémentaire entre le capot et le boitier.

Par exemple, Les rivets ont une tête plate pour limiter l'encombrement du circuit de refroidissement.

Selon un mode de réalisation, la couche de colle a une épaisseur comprise entre 10 et 300 µm.

Selon un mode de réalisation, la couche de colle a une largeur comprise entre 2 et 8 mm.

Selon un mode de réalisation, la couche de colle comprend une colle silicone ou une colle epoxy, notamment une colle epoxy sans charges.

Selon un mode de réalisation, la portion du rivet comprise dans un trou traversant correspondant le recevant a une largeur comprise entre 2 et 6 mm.

Selon un mode de réalisation, un trou traversant recevant le rivet a une largeur supérieure de 0,5 mm par rapport à la largeur de la portion du rivet située dans ledit trou traversant.

Selon un mode de réalisation, deux rivets successifs le long de la périphérie de l'ouverture sont séparés d'une distance comprise entre 30 et 60 mm.

Selon un mode de réalisation, les surfaces du capot et du boitier en contact avec la couche de colle ont respectivement une rugosité Ra comprise entre 1 et 5 µm.

L'invention concerne aussi un dispositif électrique comprenant un composant électrique et un circuit de refroidissement selon l'invention, ledit composant électrique étant monté sur une paroi du circuit de refroidissement de manière à être refroidi par le fluide de refroidissement.

Selon un mode de réalisation, le dispositif électrique forme un chargeur électrique.

L'invention va être décrite en détail dans la description qui suit en liaison avec les dessins ci-annexés. Il est à noter que ces dessins n'ont d'autre but que d'illustrer le texte de la description et ne constituent en aucune sorte une limitation de la portée de l'invention.

La figure 1 est une vue de coupe d'un dispositif électrique comprenant un exemple de circuit de refroidissement selon l'invention.

La figure 2 illustre un premier exemple de circuit de refroidissement utilisable dans le dispositif électrique de la figure 1.

La figure 3 illustre un deuxième exemple de circuit de refroidissement utilisable dans le dispositif électrique de la figure 1.

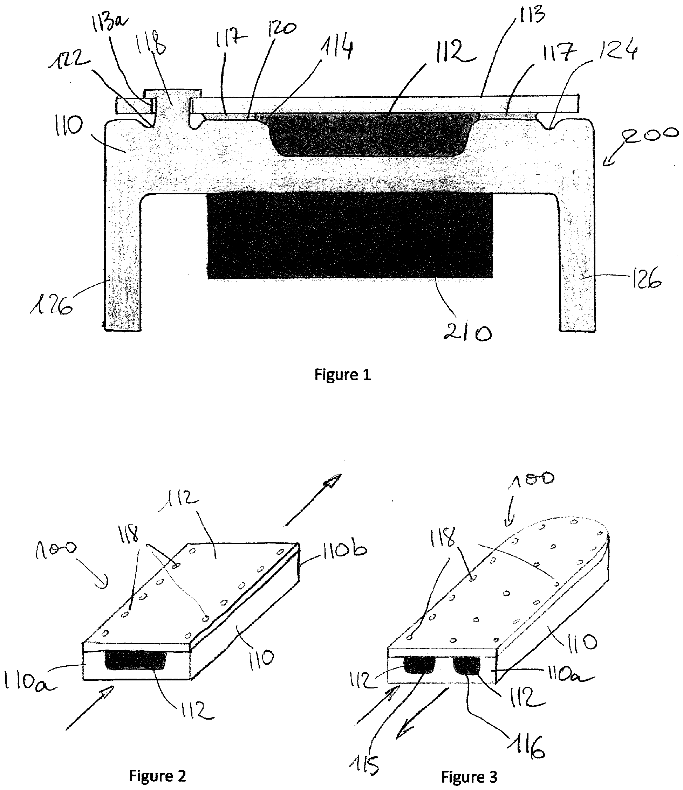

Le circuit de refroidissement selon l'invention va être mieux compris en faisant référence aux figures 1 à 3.

Le circuit de refroidissement 100 comprend un boitier 110 qui forme une cavité 112 recevant un fluide de refroidissement. Le fluide de refroidissement permet de drainer une chaleur produite par un composant électrique, par exemple un composant électrique 210 monté sur une paroi du circuit de refroidissement comme illustré en figure 1. Un capot 113 vient fermer une première ouverture 114 de la cavité 113, définissant ainsi un canal de circulation du fluide de refroidissement.

Le canal de refroidissement peut être rectiligne comme illustré en figure 2. Notamment, la cavité 112 est alors ouverte à une première extrémité 110a du boitier 110 pour recevoir le fluide de refroidissement et à une deuxième extrémité 110b du boitier 110, opposée à la première extrémité 100a, pour permettre la sortie du fluide de refroidissement. La deuxième extrémité 110b n'est pas illustrée en figure 2, mais est similaire à la première extrémité 110a. Les première 110a et deuxième 110b extrémités viennent respectivement en contact étanche avec des ports d'entrée et de sortie du fluide de refroidissement (non représentés).

Le canal de refroidissement peut être en forme de U comme illustré en figure 3. Notamment, le fluide de refroidissement est alors acheminé dans, et hors de, la cavité 112 par l'intermédiaire de la même extrémité 110a du boitier 110. A cet effet, la cavité peut avoir une deuxième ouverture 115 qui vient en contact étanche avec un port d'entrée du fluide de refroidissement (non représenté) ; et une troisième ouverture 116 qui vient en contact étanche avec un port de sortie du fluide de refroidissement (non représenté), situés sur la même extrémité 110a du boitier 110.

Le circuit de refroidissement 100 comprend des rivets 118 et une couche de colle 117 positionnée entre le capot 110 et une périphérie de la première ouverture 114, en particulier une périphérie immédiate de la première ouverture 114. L'association de la couche de colle 117 et des rivets 118 permet de fixer le capot 113 sur le boitier 110 de manière étanche. La couche de colle 117 permet une fixation du capot 113 sur le boitier 110, mais aussi une étanchéité entre le capot 113 et le boitier 110. En particulier, le circuit de refroidissement 100 est dépourvu de joint d'étanchéité supplémentaire entre le capot 113 et le boitier 110, l'étanchéité étant obtenue par la couche de colle 117 comprimée par les rivets 118.

Notamment, la couche de colle 117 est en contact avec le capot 113 et avec le boitier 110, en particulier sur des portions du capot 113 et du boitier 110 qui sont périphériques à l'ouverture 114 lorsque le capot 113 est en position sur le boitier 110. En particulier, les surfaces du capot 113 et du boitier 110 qui sont en contact avec la couche de colle 117 ont chacune une rugosité Ra comprise entre 1 et 5 µm de manière à permettre une adhésion de la couche de colle 117 sur elles et obtenir ainsi une étanchéité durable dans le circuit de refroidissement 100. La rugosité désigne une profondeur caractéristique des stries sillonnant les surfaces. Notamment, les surfaces du capot 113 et du boitier 110 qui sont en contact avec la couche de colle 117 ont une planéité inférieure ou égale à 0,1 mm entre deux rivets 118 successifs le long de la périphérie de la première ouverture 114. La planéité d'une surface désigne une distance maximale entre un point du plan et un plan parfaitement plat. Cette planéité permet d'améliorer l'étanchéité obtenue par la couche de colle 117.

En particulier, la couche de colle 117 s'étend continûment autour de l'ouverture 114 sur une première portion périphérique 120 de l'ouverture 114 et les rivets 118 sont situés sur une deuxième portion périphérique 122 externe par rapport à la première portion périphérique 120. Ainsi, la fixation entre le capot 113 et le boitier 110 par les rivets 118 et celle par la couche de colle 117 sont réalisées sur deux lignes concentriques différentes, la ligne de la couche de colle 117 étant dans la zone interne définie par la ligne des rivets 118. Ainsi, les rivets 118 ne créent pas de zones non étanches dans la couche de colle 117 ; et, en étant positionnés à l'extérieur par rapport à la couche de colle 117, les rivets 118 ne sont pas dans la zone étanche délimitée par la couche de colle 117, ce qui évite une gestion de l'étanchéité au niveau des rivets 118.

En particulier, les rivets 118 sont venus de matière avec le boitier 110 et passent par des trous traversants correspondant 113a du capot 113. Les rivets 118 ont notamment une tête plate pour limiter l'encombrement du circuit de refroidissement. Avant son écrasement, il est préférable que la tête du rivet 118 dépasse du trou traversant 113a de 2 mm, ou d'au moins 2 mm. Après son écrasement, il est préférable que la tête du rivet 118 ait une épaisseur supérieure ou égale à 1 mm. Ceci afin d'obtenir un rivet 118 réalisant un maintien mécanique durable.

La couche de colle 117 et les rivets 118 peuvent avoir des caractéristiques assurant une tenue de la fixation et de l'étanchéité pendant la durée de vie du circuit de refroidissement 100, ou du dispositif électrique 200.

Par exemple, la couche de colle 117 peut avoir une épaisseur comprise entre 10 et 300 µm. L'épaisseur correspond à la dimension de la couche de colle 117 dans une direction suivant laquelle le capot 113 et la première périphérie 120 de l'ouverture 114 sont superposés. Par exemple, la couche de colle 117 a une largeur comprise entre 2 et 8 mm. La largeur correspond à la dimension suivant laquelle la couche de colle 117 est étalée sur le boitier 110.

La couche de colle 117 peut être en différent matériau suivant la pression exercée par le fluide de refroidissement lors du fonctionnement du circuit de refroidissement. Par exemple, pour des pressions absolues comprises entre 1,5 et 3,5 bar, il est préférable qu'une colle epoxy soit utilisée. Pour des valeurs de pression absolue inférieures à 1,5 bar une colle en silicone peut être utilisée. La colle peut aussi être choisie en fonction de la composition du fluide de refroidissement. Par exemple, le fluide de refroidissement peut être à base de glycol. Il est alors préférable d'utiliser une colle sans charges, par exemple une colle epoxy sans charges lorsque la pression absolue est en outre comprise entre 1,5 et 3,5 bar.

Par exemple, la portion du rivet 118 qui est comprise dans le trou traversant correspondant 113a a une largeur comprise entre 2 et 6 mm qui permet d'assurer une liaison mécanique solide entre le capot 113 et le boitier 110 tout limitant l'encombrement du rivet 118 dans le circuit de refroidissement 100. La largeur du rivet 118 désigne la dimension transversale du rivet 118. Notamment, lorsque le rivet 118 a une forme cylindrique, la largeur correspond au diamètre d'une section transverse du rivet 118. De préférence, un espace supérieur à 0,5 mm sépare la portion du rivet 118 comprise dans le trou traversant 113a de la paroi interne du trou traversant 113a. Ceci permet notamment un espace pour la dilatation du rivet 118 et limite les frottements susceptibles de déformer le capot 113a lors de l'introduction du rivet 118 dans le trou traversant 113a.

Par exemple, deux rivets 118 successifs le long de la périphérie de la première ouverture 114 sont séparés d'une distance comprise entre 30 et 60 mm. En étant trop proches les rivets 118 seraient susceptibles d'exercer un effort trop important sur le capot 113 ; en étant trop éloignés les rivets 118 n'exerceraient pas une pression suffisante sur la couche de colle 117 pour atteindre une étanchéité durable.

Ces caractéristiques des rivets 118 et/ou de la couche de colle 117 sont notamment préférables pour un capot ayant une épaisseur comprise 1 et 5 mm.

Le boitier 110 peut comprendre une gorge 124 autour de la première portion périphérique 120 de l'ouverture 114. Cette gorge 124 peut être confondue avec la deuxième portion périphérique 122 autour de l'ouverture 114.

Le boitier 110 et/ou le capot 113 peuvent être en métal, notamment en aluminium. En particulier, le capot 117 et/ou le capot 113 peuvent être obtenus à partir d'une tôle emboutie ou à partir d'une fonderie en métal moulé, notamment moulé sous pression.

Le circuit de refroidissement 100 peut faire partie intégrante du dispositif électrique 200. Notamment, le boitier 110 du circuit de refroidissement 100 réalise au moins en partie un boitier du dispositif électrique 200 et permet de loger un composant électrique 210 du dispositif électrique 200. Par exemple, le boitier 110 comprend une paroi formant un fond de la cavité 112 ; et des parois latérales 126 s'étendant depuis une face de la paroi qui est opposée à celle située du côté de la cavité 112. Les parois latérales 126 sont notamment configurées pour former un logement recevant le composant électrique 210. Le composant électrique 210 peut être fixé sur la paroi formant le fond de la cavité 112 de manière à être refroidi par le fluide de refroidissement circulant dans la cavité 112.

Le dispositif électrique 200 est notamment un chargeur électrique. En particulier, le dispositif électrique est un chargeur électrique 200 configuré pour charger une batterie d'un véhicule, par exemple une batterie pour alimenter un moteur électrique destiné à entrainer le véhicule.

Le circuit de refroidissement selon l'invention permet d'assurer des niveaux d'étanchéité très élevés sans aucune vis et dans un encombrement en hauteur réduit. Par rapport à des circuits de refroidissement de l'art antérieur, l'exigence sur la planéité des pièces à assembler est plus faible. Le capot 113 peut être assemblé rapidement avec le boitier 110 avec des outils industriels standards, tels qu'un robot pour déposer la couche de colle 117 et une presse électrique pour former les têtes des rivets 118. Le circuit de refroidissement 100 obtenu a un cout moins élevé que dans l'art antérieur.

L'invention ne se limite pas aux seuls exemples décrits ci-dessus. Les figures représentent des exemples particuliers de réalisation qui combinent plusieurs modes de réalisation. Cependant, les caractéristiques liées aux modes de réalisation peuvent-être indépendantes entre elles d'un mode à l'autre, ou combinées entre elles, comme cela ressort des revendications.

## Revendications

1. Circuit de refroidissement (100) apte à recevoir un fluide de refroidissement, configuré pour être intégré dans un dispositif électrique (200), ledit circuit de refroidissement (100) comprenant :
- un boitier (110) formant une cavité (112) configurée pour recevoir ledit fluide de refroidissement,
- un capot (113) fermant une ouverture (114) de la dite cavité (112) de manière à définir un canal de circulation dudit fluide de refroidissement,
- une couche de colle (117) entre ledit capot (113) et la périphérie de ladite ouverture (114) et des rivets (118), la couche de colle (117) et les rivets (118) étant configurés de sorte à fixer de manière étanche ledit capot (113) sur la périphérie de ladite ouverture (114) dans lequel la couche de colle (117) s'étend continûment autour de l'ouverture (114) sur une première portion périphérique (120) de l'ouverture (114) et les rivets (118) sont situés sur une deuxième portion périphérique (122) de l'ouverture (114) externe par rapport à la première portion périphérique.

2. Circuit de refroidissement (100) selon la revendication 1, dans lequel la couche de colle (117) a une épaisseur comprise entre 10 et 300 µm.

3. Circuit de refroidissement (100) selon l'une des revendications précédentes, dans lequel la couche de colle (117) a une largeur comprise entre 2 et 8 mm.

4. Circuit de refroidissement (100) l'une des revendications précédentes, dans lequel la couche de colle (117) comprend une colle silicone ou une colle epoxy, notamment une colle epoxy sans charges.

5. Circuit de refroidissement (100) selon l'une des revendications précédentes, dans lequel la portion du rivet comprise dans un trou traversant (113a) correspondant le recevant a une largeur comprise entre 2 et 6 mm.

6. Circuit de refroidissement (100) selon l'une des revendications précédentes, dans lequel un trou traversant (113a) recevant le rivet (118) a une largeur supérieure de 0,5 mm par rapport à la largeur de la portion du rivet située dans ledit trou traversant (113a).

7. Circuit de refroidissement (100) selon l'une des revendications précédentes, dans lequel deux rivets (118) successifs le long de la périphérie de l'ouverture (114) sont séparés d'une distance comprise entre 30 et 60 mm.

8. Circuit de refroidissement (100) selon l'une des revendications précédentes, dans lequel les surfaces du capot (113) et du boitier (110) en contact avec la couche de colle (117) ont respectivement une rugosité Ra comprise entre 1 et 5 µm.

9. Dispositif électrique (200) comprenant un composant électrique (210) et un circuit de refroidissement (100) selon l'une des revendications précédentes, ledit composant électrique (210) étant monté sur une paroi du circuit de refroidissement (100) de manière à être refroidi par le fluide de refroidissement.

10. Dispositif électrique (200) selon la revendication précédente, formant un chargeur électrique.

## Patentansprüche

1. Kühlkreislauf (100), welcher geeignet ist, ein Kühlfluid aufzunehmen, und dafür ausgelegt ist, in eine elektrische Vorrichtung (200) integriert zu werden, wobei der Kühlkreislauf (100) umfasst:
- ein Gehäuse (110), das einen Hohlraum (112) bildet, der dafür ausgelegt ist, das Kühlfluid aufzunehmen,
- eine Haube (113), die eine Öffnung (114) des Hohlraums (112) so verschließt, dass sie einen Strömungskanal des Kühlfluids definiert,
- eine Klebstoffschicht (117) zwischen der Haube (113) und dem Umfang der Öffnung (114) und Niete (118), wobei die Klebstoffschicht (117) und die Niete (118) so ausgebildet sind, dass sie die Haube (113) dicht auf dem Umfang der Öffnung (114) befestigen, wobei sich die Klebstoffschicht (117) durchgehend um die Öffnung (114) herum auf einem ersten Umfangsabschnitt (120) der Öffnung (114) erstreckt und die Niete (118) sich auf einem zweiten Umfangsabschnitt (122) der Öffnung (114) befinden, der in Bezug auf den ersten Umfangsabschnitt außen liegt.

2. Kühlkreislauf (100) nach Anspruch 1, wobei die Klebstoffschicht (117) eine Dicke zwischen 10 und 300 µm aufweist.

3. Kühlkreislauf (100) nach einem der vorhergehenden Ansprüche, wobei die Klebstoffschicht (117) eine Breite zwischen 2 und 8 mm aufweist.

4. Kühlkreislauf (100) nach einem der vorhergehenden Ansprüche, wobei die Klebstoffschicht (117) einen Silikonkleber oder einen Epoxidharzkleber, insbesondere einen Epoxidharzkleber ohne Zusätze, umfasst.

5. Kühlkreislauf (100) nach einem der vorhergehenden Ansprüche, wobei der Abschnitt des Nietes, der sich in einem entsprechenden Durchgangsloch (113a), das ihn aufnimmt, befindet, eine Breite zwischen 2 und 6 mm aufweist.

6. Kühlkreislauf (100) nach einem der vorhergehenden Ansprüche, wobei ein Durchgangsloch (113a), das den Niet (118) aufnimmt, eine Breite aufweist, die um 0,5 mm größer als die Breite des Abschnitts des Nietes ist, der sich in dem Durchgangsloch (113a) befindet.

7. Kühlkreislauf (100) nach einem der vorhergehenden Ansprüche, wobei zwei Niete (118), die entlang des Umfangs der Öffnung (114) aufeinander folgen, durch einen Abstand getrennt sind, der zwischen 30 und 60 mm beträgt.

8. Kühlkreislauf (100) nach einem der vorhergehenden Ansprüche, wobei die Flächen der Haube (113) und des Gehäuses (110), die sich in Kontakt mit der Klebstoffschicht (117) befinden, jeweils eine Rauheit Ra zwischen 1 und 5 µm aufweisen.

9. Elektrische Vorrichtung (200), welche eine elektrische Komponente (210) und einen Kühlkreislauf (100) nach einem der vorhergehenden Ansprüche umfasst, wobei die elektrische Komponente (210) an einer Wand des Kühlkreislaufs (100) so angebracht ist, dass sie durch das Kühlfluid gekühlt wird.

10. Elektrische Vorrichtung (200) nach dem vorhergehenden Anspruch, welche ein elektrisches Ladegerät bildet.

## Claims

1. Cooling circuit (100) capable of receiving a coolant, configured to be incorporated in an electrical device (200), said cooling circuit (100) comprising:
- a housing (110) forming a cavity (112) configured to receive said coolant,
- a cap (113) closing an opening (114) of said cavity (112) so as to define a circulation channel for said coolant,
- a layer of glue (117) between said cap (113) and the periphery of said opening (114) and rivets (118), the layer of glue (117) and the rivets (118) being configured so as to tightly fix said cap (113) onto the periphery of said opening (114) in which the layer of glue (117) extends continually around the opening (114) over a first peripheral portion (120) of the opening (114) and the rivets (118) are situated on a second peripheral portion (122) of the opening (114) that is outer with respect to the first peripheral portion.

2. Cooling circuit (100) according to Claim 1, wherein the layer of glue (117) has a thickness of between 10 and 300 µm.

3. Cooling circuit (100) according to one of the preceding claims, wherein the layer of glue (117) has a width of between 2 and 8 mm.

4. Cooling circuit (100) according to one of the preceding claims, wherein the layer of glue (117) comprises a silicone glue or an epoxy glue, notably an epoxy glue without fillers.

5. Cooling circuit (100) according to one of the preceding claims, wherein the portion of the rivet contained in a corresponding through-hole (113a) receiving it has a width of between 2 and 6 mm.

6. Cooling circuit (100) according to one of the preceding claims, wherein a through-hole (113a) receiving the rivet (118) has a width greater than 0.5 mm with respect to the width of the portion of the rivet situated in said through-hole (113a).

7. Cooling circuit (100) according to one of the preceding claims, wherein two successive rivets (118) along the periphery of the opening (114) are separated by a distance of between 30 and 60 mm.

8. Cooling circuit (100) according to one of the preceding claims, wherein the surfaces of the cap (113) and of the housing (110) in contact with the layer of glue (117) respectively have a roughness Ra of between 1 and 5 µm.

9. Electrical device (200) comprising an electrical component (210) and a cooling circuit (100) according to one of the preceding claims, said electrical component (210) being mounted on a wall of the cooling circuit (100) so as to be cooled by the coolant.

10. Electrical device (200) according to the preceding claim, forming an electrical charger.
